# EUROPÄISCHE PATENTSCHRIFT

(11) **EP 0 624 263 B1**
(45) Veröffentlichungstag und Bekanntmachung des Hinweises auf die Patenterteilung: **27.03.1996**
(21) Anmeldenummer: 92919410.8
(22) Anmeldetag: 10.09.1992
(51) Int. Cl.: G03F 7/36, G03F 7/075, H01L 21/311

(54) **VERFAHREN ZUR TROCKENENTWICKLUNG EINER SILIZIUMHALTIGEN ULTRAVIOLETT- UND/ODER ELEKTRONENSTRAHLEMPFINDLICHEN LACKSCHICHT**
METHOD FOR THE DRY DEVELOPMENT OF A SILICON-CONTAINING LACQUER FILM SENSITIVE TO UV AND/OR ELECTRON-BEAM RADIATION
PROCEDE DE DEVELOPPEMENT A SEC D'UNE COUCHE DE VERNIS A TENEUR EN SILICIUM, SENSIBLE AUX RAYONS ULTRAVIOLETS ET/OU AUX FAISCEAUX D'ELECTRONS

(30) Priorität: 30.01.1992 DE 4202651
(43) Veröffentlichungstag der Anmeldung: 17.11.1994
(73) Patentinhaber: FRAUNHOFER-GESELLSCHAFT ZUR FÖRDERUNG DER ANGEWANDTEN FORSCHUNG E.V., D-80636 München (DE)
(72) Erfinder: KLUMPP, Armin, D-80337 München (DE); HACKER, Erwin, D-87600 Kaufbeuren (DE)
(74) Vertreter: Schoppe, Fritz, Dipl.-Ing.
(86) Internationale Anmeldenummer: DE9200779
(87) Internationale Veröffentlichungsnummer: WO9315444

(56) Entgegenhaltungen:
- EP-A- 0 379 301
- WO-A-85/02030
- US-A- 4 307 180
- US-A- 4 631 248
- US-A- 4 675 273
- Dialog Information Services, File 351, World Patent Index 81-92, Dialog accession no. 003992365, WPI accession no. 84-137909/22, TOKYO DENSHI KAGAKU: "Resist pattern prodn. by dry development method involves exposing sensitive resin layer to uv radiation and developing using plasma generated by previously cooled gas" & JP A, 59-72441

## Beschreibung

Die vorliegende Erfindung befaßt sich mit einem Verfahren zur Trockenentwicklung einer siliziumhaltigen ultraviolett-und/oder elektronenstrahlempfindlichen Lackschicht nach dem Oberbegriff des Patentanspruchs 1.

Allgemein befaßt sich die Erfindung mit der Entwicklung von solchen Lackschichten, welche als Maskenschichten bei der photolithographischen Herstellung elektronischer Schaltkreise benötigt werden.

Im Stand der Technik wird diese Lackschicht, welche auch als Top-Resist-Lack bezeichnet wird, in einem Schleuderverfahren, welches auch als Spin-on-Technologie bezeichnet wird, als dünne Polymerschicht auf die Waferoberfläche aufgebracht. Vor diesem Aufbringen in einem Schleuderverfahren werden die Lacke in aufwendigen vorbereitenden Verfahren präpariert. Je nach den gewünschten späteren Einsatzbereichen bezüglich der Wellenlänge und Empfindlichkeit werden in die Lacke funktionelle Gruppen mit eingebaut, bei denen es sich beispielsweise um Ethoxy**l**, Hydroxy**l** mit Katalysator, Vinyl, Chloromethyl, Phenylallyl, Chloromethylphenylethyl oder um Si-Me handelt. Die belichteten Bereiche derartiger Lackschichten sind gegenüber organischen Lösungsmitteln unlöslich. Daher kann bei derartigen bekannten Lackschichten eine Entwicklung durch Lösen der nicht-belichteten Lackschichtenbereiche in einem organischen Lösungsmittel erfolgen.

Eine derartige Naßentwicklung steht jedoch einer Integration in andere halbleitertechnologische Verfahrensabläufe entgegen. So ist es heutzutage beispielsweise üblich, sich zur Vermeidung eines Reinraumes einer sogenannten "Clustertool"-Vorrichtung zu bedienen, welche eine zentrale Handhabungseinheit umfaßt, an die über eine Schleuse in einer Ladebox Wafer übergeben werden können, wobei diese zentrale Handhabungseinheit evakuiert ist. Von dieser aus werden die Wafer der Reihe nach von einer Prozeßstation zur nächsten übertragen. Für den Einsatz in einer solchen Technologie eignen sich nur trockene Verfahren.

Bei bekannten Entwicklungsverfahren liegt es nach Durchführung der Belichtung des Lackes fest, welche Bereiche bei der nachfolgenden Entwicklung entfernt werden und welche Bereiche stehen bleiben. Typischerweise bleibt bei bekannten Verfahren der Lack an den belichteten Stellen stehen, so daß sich eine Negativbild der ursprünglichen Beleuchtungsverteilung ergibt. Vielfach ist es jedoch gewünscht, zwischen einem Positivbild und einem Negativbild wählen zu können.

Ergänzend werden zum technologischen Hintergrund der Erfindung folgende Schriften genannt, die sich mit siliziumhaltigen ultraschall- und elektronenstrahlempfindlichen Lackschichten befassen:
Novel Si-Containing Resist, Y. Yamashita, M. Kaziwara, J. Electrochem. Soc., Band 137, Nr. 10, Okt. 1990, Seiten 3253 bis 3257;
Submicron Pattern Transfer With New Designed e⁻ - beam Resist and bias-ECR Etcher, S. Sogito, S. Ishida, Y. Iida, Microelectronic Engineering 9, 1989, Seiten 533 bis 536;
Polysiloxanes with Pendant Cinnamoyl Groups: As a negative Deep UV Resist for Bilayer Applications, C. Rosilis, A. Rosilio and B. Serre-Monanda, J. Electrochem, Soc., Band 136, Nr. 8, Aug. 1989, Seiten 2350 bis 2354;
A Comparison for the E-beam Sensitivitites and Relative O₂-plasma Stabilities of Organosilicon Polymers, E. Babich et al., Microelectronic Engineering 9, 1989, Seiten 537 bis 542; und
Novel Process for Direct Delineation of Spin on Glass (SOG), A. Imai et al., Jap. J. of Appl. Physics, Band 29, November 1990, Seite 2653.

Ausgehend von diesem Stand der Technik liegt der vorliegenden Erfindung die Aufgabe zugrunde, ein Trockenentwicklungsverfahren für eine ultraviolett- und/oder elektronenstrahlempfindliche Lackschicht zu schaffen.

Diese Aufgabe wird durch ein Trockenentwicklungsverfahren gemäß Patentanspruch 1 gelöst.

Bevorzugte Weiterbildungen sind in den Unteransprüchen angegeben.

Nachfolgend wird unter Bezugnahme auf die beiliegenden Zeichnungen ein bevorzugtes Ausführungsbeispiel des erfindungsgemäßen Verfahrens näher erläutert. Es zeigen:
- Fig. 1: eine Kontrast- und Empfindlichkeitskurve für eine UV-belichtete Lackschicht bei Entwicklung als Negativbild;
- Fig. 2: eine Kontrast- und Empfindlichkeitskurve für eine UV-belichtete Lackschicht bei Entwicklung als Positivbild; und
- Fig. 3: eine Kontrast- und Empfindlichkeitskurve für eine elektronenstrahlbelichtete Lackschicht bei Entwicklung als Positivbild.

Das erfindungsgemäße Verfahren geht aus von der Erzeugung einer Lackschicht, die in ihrer Zusammensetzung homogen ist und Vinylgruppen, SiO₂, Silizium und kurze Kohlenwasserstoffketten umfaßt. In bevorzugter Weise wird diese Schicht durch plasmainduziertes Abscheiden von Trivinylmethylsilan (TVMS) als Lieferant der Vinylgruppen und Oktamethylcyclotetrasiloxan als Silizium- bzw. SiO₂-Quelle erzeugt. Diese Stoffe sind bei Raumtemperatur flüssig und werden nach Dosierung über Flüssigkeitsmassendurchflußregler innerhalb einer Anlage verdampft, wobei typische HF-Leistungsdichten von 0,06 bis 0,6 W/cm Anwendung finden. Der Druckbereich wird zwischen 0,3 mbar und 1,5 mbar eingestellt. Die Substrattemperatur wird zwischen 20° C und 90° C festgelegt.

Während eines nachfolgenden UV-Belichtungsschrittes oder Elektronenstrahlbelichtungsschrittes wird diese Schicht in ihrem chemischen Verhalten modifiziert, wodurch ein latentes Bild erzeugt wird. Die Belichtung bewirkt in der Schicht eine Vernetzung von Si-Atomen über -CH₂- oder -CH₂CH₂-Bindungen.

Die Entwicklung des so erzeugten latenten Bildes erfolgt durch eine Ätzgasmischung im Plasma. Die Ätzgasmischung enthält wenigstens zwei Ätzgase, die derart gewählt sind, daß sie Silizium und Kohlenstoff in eine flüchtige Verbindung überführen können. Eines der beiden Ätzgase muß eine Tendenz zur Polymerisation aufweisen.

Beispielshafte, bevorzugte Ätzgase sind Sauerstoff und Trifluormethan CHF₃. Bei Wahl dieser Ätzgase reagiert Sauerstoff mit Kohlenstoff in der Lackschicht. Sauerstoff reagiert weiterhin mit Kohlenstoff im Trifluormethan CHF₃, wodurch Fluor freigesetzt wird, das seinerseits Silizium aus der Lackschicht in flüchtiges SiF₄ überführt.

Ganz besondere Bedeutung kommt im Rahmen der Erfindung der Tatsache zu, daß in Abhängigkeit von den Mischungsverhältnissen der Ätzgase und deren Reaktionsdruck wahlweise ein Bild der ursprünglichen Beleuchtungsverteilung erzielt wird, bei dem der Lack an den belichteten Stellen in Form eines Negativbildes stehen bleibt, oder eine Umkehr der Verteilung erreicht wird, wobei die Lackschicht an den belichteten Stellen entfernt wird, so daß ein Positivbild besteht.

Mit anderen Worten können bei dem erfindungsgemäßen Verfahren wahlweise ein Negativbild oder ein Positivbild in Abhängigkeit von den Mischungsverhältnissen der Ätzgase und dem Reaktionsdruck ausgewählt werden. Für UV-belichtete Lackschichten, die also mit einer Wellenlänge von weniger als 200 nm belichtet sind, erhält man eine negative Entwicklung für Drücke ≤ 0,2 mbar bei einem O₂/CHF₃-Verhältnis ≥ 3:1. Hier ergibt sich eine positive Bildentwicklung für Drücke oberhalb von 0,5 mbar bei einem O₂/CHF₃-Verhältnis ≤ 1:3.

Für elektronenstrahlbelichtete Lackschichten ergibt sich eine negative Bildentwicklung für Drücke oberhalb von 0,2 mbar bei einem O₂/CHF₃-Verhältnis ≤ 1:3, wobei eine positive Bildentwicklung für Drücke unterhalb von 0,2 mbar bei einem O₂/CHF₃-Verhältnis ≥ 3:1 erhalten wird.

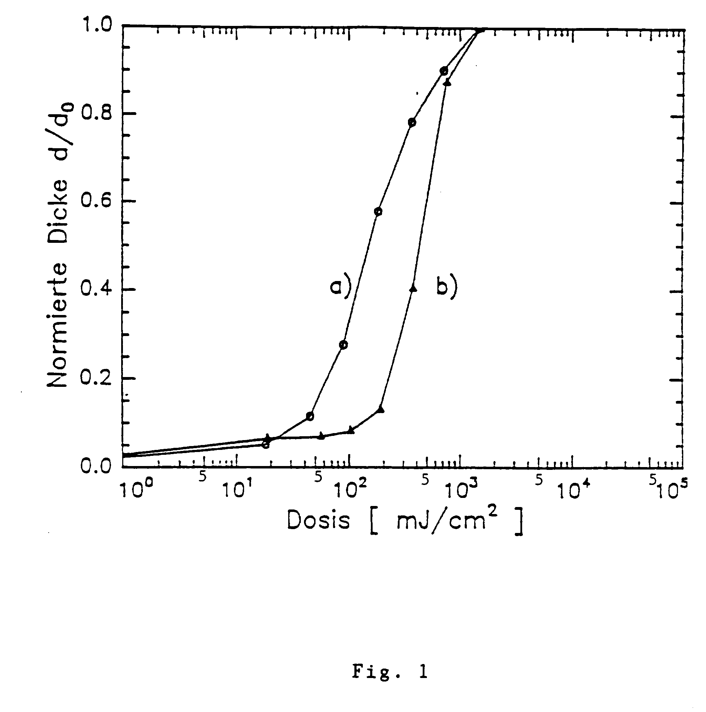

Fig. 1 verdeutlicht die Kontrast- und Empfindlichkeitskurve für eine UV-belichtete Lackschicht. Es sind zwei Kurvenverläufe gezeigt, die mit a bzw. b bezeichnet sind. Die mit a bezeichnete Kurve entspricht dem Empfindlichkeits- und Kontrastverlauf für ein O₂/CHF₃-Verhältnis von 13:1 bei einem Druck von 0,2 mbar und einer HF-Leistung für die Verdampfung der Gase von 70 W. Der mit b bezeichnete Verlauf entspricht einem O₂/CHF₃-Verhältnis von 7:1 bei einem Druck von 0,2 mbar und einer HF-Leistung von 45 W.

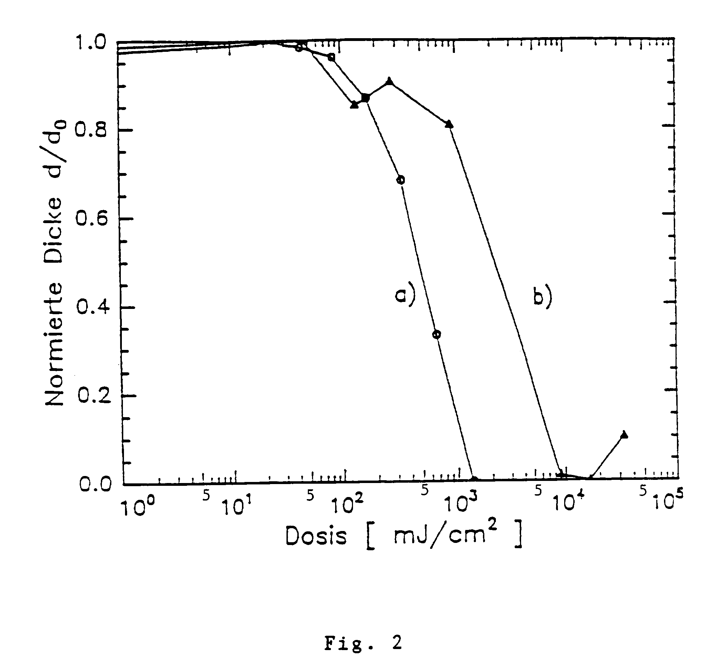

Demgegenüber zeigt Fig. 2 die Kontrast- und Empfindlichkeitskurve für eine UV-belichtete Lackschicht bei einer Entwicklung als Positivbild. Die Kurve a zeigt ein O₂/CHF₃-Verhältnis von 1:25 bei einem Druck von 1,0 mbar, wobei die HF-Leistung 70 W beträgt. Die Kurve b entspricht einem O₂/CHF₃-Verhältnis von 3:17 gleichfalls bei einem Druck von 1,0 mbar, wobei die hier gewählte HF-Leistung 50 W beträgt.

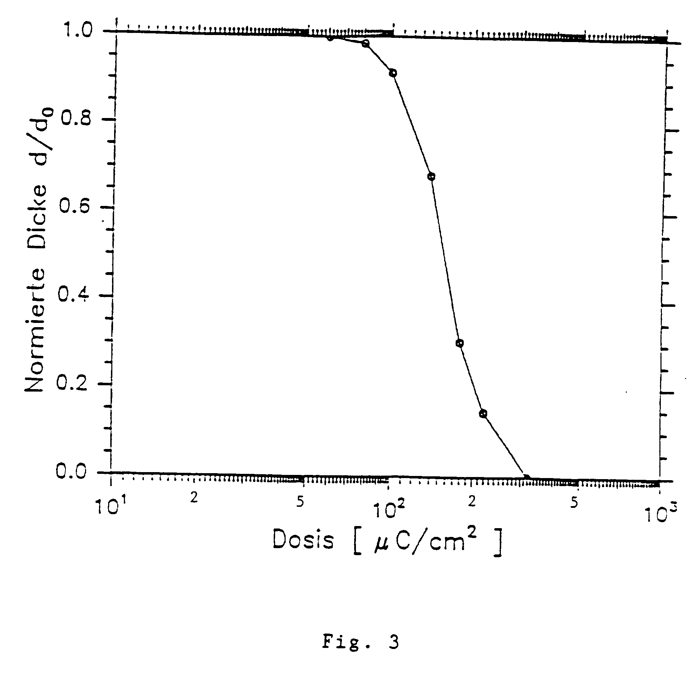

Letztlich wird unter Bezugnahme auf Fig. 3 die Empfindlichkeits- und Kontrastkurve für eine elektronenstrahlbelichtete Lackschicht bei Entwicklung als Positiv gezeigt. Das O₂/CHF₃-Verhältnis beträgt 6:2 bei einem Druck von 0,2 mbar. Die HF-Leistung ist 45 W.

## Patentansprüche

1. Verfahren zur Trockenentwicklung einer siliziumhaltigen ultraviolettempfindlichen Lackschicht, die wahlweise eine negative Bildentwicklung, bei der die Lackschicht an ihren belichteten Bereichen verbleibt, oder eine positive Bildentwicklung, bei der die Lackschicht an ihren unbelichteten Bereichen verbleibt, bewirkt, bei dem
a) bei dem die Lackschicht durch Abscheiden von linearen oder zyklischen Siloxanen mit Vinylsilanen aus der Gasphase erzeugt wird,
b) die Lackschicht durch UV-Belichtung in ihrem chemischen Verhalten derart modifiziert wird, daß ein latentes Bild erzeugt wird,
c) die Entwicklung des latenten Bildes durch eine Ätzgasmischung im Plasma erfolgt,
d) die Ätzgasmischung wenigstens das Ätzgas Sauerstoff und das Ätzgas Trifluormethan CHF₃, welches eine Tendenz zur Polymerisation aufweist, umfaßt, die gemeinschaftlich Silizium und Kohlenstoff in eine flüchtige Verbindung überführen können, wobei Sauerstoff mit Kohlenstoff in der Lackschicht reagiert, Sauerstoff ferner mit Kohlenstoff im Trifluormethan CHF₃ reagiert, wodurch Fluor freigesetzt wird, und Fluor Silizium aus der Lackschicht in flüchtiges SiF₄ überführt, wobei
e) eine negative Bildentwicklung nach der UV-Belichtung bei Drücken der Ätzgasmischung unterhalb von 0,2 mbar bei einem O₂/CHF₃-Verhältnis ≥ 3:1 erhalten wird, oder wahlweise
f) eine positive Bildentwicklung nach der UV-Belichtunq bei Drücken der Ätzgasmischung oberhalb von 0,5 mbar bei einem O₂/CHF₃-Verhältnis ≤ 1:3 erhalten wird.

2. Verfahren zur Trockenentwicklung einer siliziumhaltigen elektronenstrahlempfindlichen Lackschicht, die wahlweise eine negative Bildentwicklung, bei der die Lackschicht an ihren belichteten Bereichen verbleibt, oder eine positive Bildentwicklung, bei der die Lackschicht an ihren unbelichteten Bereichen verbleibt, bewirkt, bei dem
a) bei dem die Lackschicht durch Abscheiden von linearen oder zyklischen Siloxanen mit Vinylsilanen aus der Gasphase erzeugt wird,
b) die Lackschicht durch Elektronenstrahlbelichtung in ihrem chemischen Verhalten derart modifiziert wird, daß ein latentes Bild erzeugt wird,
c) die Entwicklung des latenten Bildes durch eine Ätzgasmischung im Plasma erfolgt,
d) die Ätzgasmischung wenigstens das Ätzgas Sauerstoff und das Ätzgas Trifluormethan CHF₃, welches eine Tendenz zur Polymerisation aufweist, umfaßt, die gemeinschaftlich Silizium und Kohlenstoff in eine flüchtige Verbindung überführen können, wobei Sauerstoff mit Kohlenstoff in der Lackschicht reagiert, Sauerstoff ferner mit Kohlenstoff im Trifluormethan CHF₃ reagiert, wodurch Fluor freigesetzt wird, und Fluor Silizium aus der Lackschicht in flüchtiges SiF₄ überführt, wobei
e) eine negative Bildentwicklung nach der Elektronenstrahl-Belichtung bei Drücken der Ätzgasmischung oberhalb von 0,2 mbar bei einem O₂/CHF₃-Verhältnis ≤ 1:3 erhalten wird, oder wahlweise
f) eine positive Bildentwicklung nach der Elektronenstrahl-Belichtung bei Drücken der Ätzgasmischung oberhalb von 0,2 mbar bei einem O₂/CHF₃-Verhältnis ≥ 3:1 erhalten wird.

3. Verfahren zur Trockenentwicklung einer siliziumhaltigen ultraviolettempfindlichen Lackschicht nach Anspruch 1, bei dem
die Vinylsilane Trivinylmethylsilan (TVMS) und
die zyklischen Siloxane Oktamethylcyclotretrasiloxan sind.

4. Verfahren zur Trockenentwicklung einer siliziumhaltigen elektronenstrahlempfindlichen Lackschicht nach Anspruch 2, bei dem
die Vinylsilane Trivinylmethylsilan (TVMS) und
die zyklischen Siloxane Oktamethylcyclotretrasiloxan sind.

## Claims

1. A method for dry development of an ultraviolet-sensitive resist layer containing silicon and effecting selectively a negative image development in which the resist layer remains at its exposed areas or a positive image development in which the resist layer remains at its unexposed areas, wherein
a) the resist layer is produced by depositing linear or cyclic siloxanes with vinyl silanes from the gas phase,
b) the chemical behaviour of the resist layer is modified by UV exposure in such a way that a latent image will be produced,
c) the latent image is developed by means of an etch gas mixture in plasma,
d) the etch gas mixture comprises at least the etch gas oxygen and the etch gas trifluoromethane CHF₃, which has a tendency towards polymerization, said two etch gases being jointly capable of converting silicon and carbon into a volatile compound, oxygen reacting with carbon in the resist layer, and oxygen reacting also with carbon in the trifluoromethane CHF₃, whereby fluorine is set free, and fluorine converting silicon of said resist layer into volatile SiF₄,
e) a negative image development after the UV exposure being obtained at pressures of the etch gas mixture below 0.2 mbar and at an O₂/CHF₃ ratio ≥ 3:1, or, selectively,
f) a positive image development after the UV exposure being obtained at pressures of the etch gas mixture exceeding 0.5 mbar and at an O₂/CHF₃ ratio ≤ 1:3.

2. A method for dry development of an electron beam sensitive resist layer containing silicon and effecting selectively a negative image development in which the resist layer remains at its exposed areas or a positive image development in which the resist layer remains at its unexposed areas, wherein
a) the resist layer is produced by depositing linear or cyclic siloxanes with vinyl silanes from the gas phase,
b) the chemical behaviour of the resist layer is modified by electron-beam exposure in such a way that a latent image will be produced,
c) the latent image is developed by means of an etch gas mixture in plasma,
d) the etch gas mixture comprises at least the etch gas oxygen and the etch gas trifluoromethane CHF₃, which has a tendency towards polymerization, said two etch gases being jointly capable of converting silicon and carbon into a volatile compound, oxygen reacting with carbon in the resist layer, and oxygen reacting also with carbon in the trifluoromethane CHF₃, whereby fluorine is set free, and fluorine converting silicon of said resist layer into volatile SiF₄,
e) a negative image development after the electron-beam exposure being obtained at pressures of the etch gas mixture exceeding 0.2 mbar and at an O₂/CHF₃ ratio ≤ 1:3, or, selectively,
f) a positive image development after the electron-beam exposure being obtained at pressures of the etch gas mixture exceeding 0.2 mbar and at an O₂/CHF₃ ratio ≥ 3:1.

3. A method for dry development of an ultravoilet-sensitive resist layer containing silicon according to claim 1, wherein
the vinyl silanes are trivinyl methyl silane (TVMS) and
the cyclic siloxanes are octamethyl cyclotetrasiloxane.

4. A method for dry development of an electron beam sensitive resist layer containing silicon according to claim 2, wherein
the vinyl silanes are trivinyl methyl silane (TVMS) and
the cyclic siloxanes are octamethyl cyclotetrasiloxane.

## Revendications

1. Procédé de développement à sec d'une couche de vernis à teneur en silicium, sensible aux rayons ultraviolets, qui entraîne, au choix, soit un développement d'image négative, dans lequel la couche de vernis demeure à ses endroits exposés à la lumière, soit un développement d'image positive, dans lequel la couche de vernis demeure à ses endroits non exposés à la lumière, dans lequel
a) la couche de vernis est produite par dégagement de siloxanes linéaires ou cycliques avec des vinylsilanes de la phase gazeuse,
b) la couche de vernis est modifiée, quant à son comportement chimique, par exposition à la lumière UV, de telle manière qu'il est généré une image latente,
c) le développement de l'image latente s'effectue par un mélange de gaz corrosifs en phase plasma,
d) le mélange de gaz corrosifs comporte au moins le gaz corrosif oxygène et le gaz corrosif trifluorométhane CHF₃, qui présente une tendance à la polymérisation, qui peuvent, ensemble, transporter du silicium et du carbonne sous forme de liaison volatile, l'oxygène réagissant avec le carbone dans la couche de vernis, l'oxygène réagissant, par ailleurs, avec le carbonne dans le trifluorométhane CHF₃, d'où il est libéré du fluor, et le fluor transporte du silicium de la couche de vernis sous forme de SiF₃ volatil,
e) obtenant ainsi un développement d'image négative après l'exposition à la lumière UV à des pressions du mélange de gaz corrosifs inférieures à 0,2 mbar, à un rapport O₂/CHF₃ ≥ 3:1, ou, au choix,
f) obtenant ainsi un développement d'image positive après l'exposition à la lumière UV à des pressions du mélange de gaz corrosifs supérieures à 0,5 mbar, à un rapport O₂/CHF₃ ≤ 1:3.

2. Procédé de développement à sec d'une couche de vernis à teneur en silicium, sensible aux faisceaux d'électrons, qui entraîne, au choix, soit un développement d'image négative, dans lequel la couche de vernis demeure à ses endroits exposés à la lumière, soit un developpement d'image positive, dans lequel la couche de vernis demeure à ses endroits non exposés à la lumière, dans lequel
a) la couche de vernis est produite par dégagement de siloxanes linéaires ou cycliques avec des vinylsilanes de la phase gazeuse,
b) la couche de vernis est modifiée, quant à son comportement chimique, par exposition à un faisceau d'électrons, de telle manière qu'il est généré une image latente,
c) le développement de l'image latente s'effectue par un mélange de gaz corrosifs en phase plasma,
d) le mélange de gaz corrosifs comporte au moins le gaz corrosif oxygène et le gaz corrosif trifluorométhane CHF₃, qui présente une tendance à la polymérisation, qui peuvent, ensemble, transporter du silicium et du carbone sous forme de liaison volatile, l'oxygène réagissant avec le carbone dans la couche de vernis, l'oxygène réagissant, par ailleurs, avec le carbone dans le trifluorométhane CHF₃, d'où il est libéré du fluor, et le fluor transporte du silicium de la couche de vernis sous forme de SiF₃ volatil,
e) obtenant ainsi un développement d'image négative après l'exposition au faisceau d'électrons à des pressions du mélange de gaz corrosifs supérieures à 0,2 mbar, à un rapport O₂/CHF₃ ≤ 1:3, ou, au choix,
f) obtenant ainsi un développement d'image positive après l'exposition au faisceau d'électrons à des pressions du mélange de gaz corrosifs supérieures à 0,2 mbar, à un rapport O₂/CHF₃ ≥ 3:1.

3. Procédé de développement à sec d'une couche de vernis à teneur en silicium, sensible aux rayons ultraviolets, suivant la revendication 1, dans lequel
les vinylsilanes sont des trivinylméthylsilanes (TVMS), et
les siloxanes cycliques sont des octaméthylcyclotétrasiloxanes.

4. Procédé de développement à sec d'une couche de vernis à teneur en silicium, sensible aux faisceaux d'électrons, suivant la revendication 2, dans lequel
les vinylsilanes sont des trivinylméthylsilanes (TVMS), et
les siloxanes cycliques sont des octaméthylcyclotétrasiloxanes.
